# EUROPEAN PATENT APPLICATION

(11) **EP 2 487 728 A2**
(43) Date of publication of application: **15.08.2012**
(21) Application number: 12000871.9
(22) Date of filing: 10.02.2012
(51) Int. Cl.: H01L 31/052, G02B 17/06

(54) **Light-collecting device and light-collecting method thereof**

(30) Priority: 14.02.2011 TW 100104786
(71) Applicant: Neo-Optic Tek. Co., Ltd., Tainan City 744 (TW)
(72) Inventor: Tsou, Yuan-Hsiang, 744 Tainan City (TW)
(74) Representative: Volpert, Marcus

(57) **Abstract**

A light-collecting device and a light-collecting method thereof are disclosed, capable of providing a simple combination structure, guiding light beams to be almost perpendicularly entered into a receiving element, and increasing the absorption efficiency of a light-receiving element. The light-collecting device includes a light concentrator and a light collector provided with total internal reflection and assembled with a light-receiving element. The light collector is defined with a light-entering aperture disposed near or located at a focusing region of the light concentrator and a light-radiating aperture. At least part of light beam received by the light concentrator travels through the focusing region of the light concentrator and forwardly radiates to the light collector, and the light beam travelling form the light collector is incident to the receiving element when the light beam is optically functioned by the total internal reflection of the light collector, thereby improving the photoelectric conversion efficiency.

## Description

### BACKGROUND OF THE INVENTION

### Field of the Invention

The present invention relates to a light-collecting system and a light-collecting method, in particular relates to a composite-design assembled structure of a light-collecting system applied for a solar photovoltaic module or a solar energy conversion mechanism to generate a more perfect light path and arrangement between light-collecting devices.

### Description of the Related Art

In conventional light-collecting systems or modules, optical lenses (e.g., Fresnel lens) and solar photovoltaic modules or chips are usually combined for collecting incident lights. A conventional light-collecting system includes optical lens or primary optical element (or a light concentrator), a secondary optical element, an optical cover plate and a bottom plate, which are fixedly assembled, or a frame can be provided between the bottom plate and the optical cover plate, such as in 'SHIELD FOR SOLAR RADIATION COLLECTOR' in US 7473000 B2 and 'PHOTOVOLTAIC CONCENTRATING APPARATUS' in US 2009/0320923.

It is understood by those who skilled in these arts in that thermal stresses are concentrated on local regions of a chip (or a photovoltaic module) when the sunlight incident to or light paths being located on the central region of the chip, reducing the life span of the chip and impacting the photoelectric conversion efficiency. Therefore, the majority of the conventional designs of the light-collecting structures are tended to acquire a large acceptance angle and uniform light effects to improve the defects above, such as 'NONIMAGING LIGHT CONCENTRATOR WITH UNIFORM IRRADIANCE' in US 6541694 B2. The acceptance angle is referred to an incident angle that the sunlight can completely enter into the light-collecting system without any errors occurred (i.e., an ideal condition). When the light incident angle of the sunlight is affected by external factors and light-collecting efficiency of 90% can be obtained, the deflection of the light incident angle is defined as the acceptance angle.

One topic related to the application of this light-collecting device is that, when acquiring a large acceptance angle and uniform light effect, it often represents that the angle of the light beam incident to the receiving element or photovoltaic module (or a chip) is increased but the light-collecting efficiency of the light-receiving element is reduced. Specifically speaking, a light-concentrating device using total internal reflection (TIR) is an example which can have a high light-collecting power and design of super-short throw. However, if attempting to use a light-receiving element which can efficiently absorb the incident light, the majority of light beams in the TIR light-concentrating device are incident to the receiving element (or a chip) at a large angle, resulting in the unexpected photoelectric efficiency of the receiving element incapable of being increased. Similarly, Cassegrain and RXI super-short throw light-collecting devices have the same conditions.

Representatively speaking, these reference data disclose the related skills of the light sources and optical components or light-collecting systems applied in the applications, and it also reflects some problems existed in certain applications of the optical components or light-collecting systems. It is possible to change the use patterns of the light-collecting modules and increase the applications thereof to distinguish from the conventional skills by redesigning and reconsidering the configurations and structures of the light-collecting modules, but several following topics in the aspect of structural design shall be considered.

Firstly, by designing and manufacturing the assembled structure of the light-collecting device based on a simple condition, including the reduce of the assembling difficulty of the light-collecting device, the manufacturing cost of the light-collecting device can be reduced. Further, by increasing the accuracies of the light-collecting elements and light-receiving element, the stabilities of the conversion performance and generator efficiency of the light-collecting device can be increased, thereby improving the photoelectric conversion efficiency caused by non-uniform optical illumination in the conventional structures.

Secondly, the majority of conventional skills are tended to improve the light-collecting device by designing the uniformity (i.e., uniform light effect) of the light-incident receiving element (or a chip) or enlarging the acceptance angle of the receiving element, but it is rarely to see the topics related to the angle of light beam incident to the receiving element (or a chip). For example, in US 7473000 B2 and US 6541694 B2, uniform light devices (or light collectors) formed by structural types of wide top portion and narrow bottom portion are provided to increase the acceptance angle of the light-collecting systems. However, it is often to increase the angle of the light beam incident to the receiving element or battery module (or a chip) and therefore to reduce the photoelectric conversion efficiency of the light receiving element when the light beam travel through the uniform light devices (or light collectors) formed by structural types of wide top portion and narrow bottom portion. Here, it is stressed that the angle of light beam incident to the receiving element (or a chip) is particularly to be considered in the light-collecting device of the present invention.

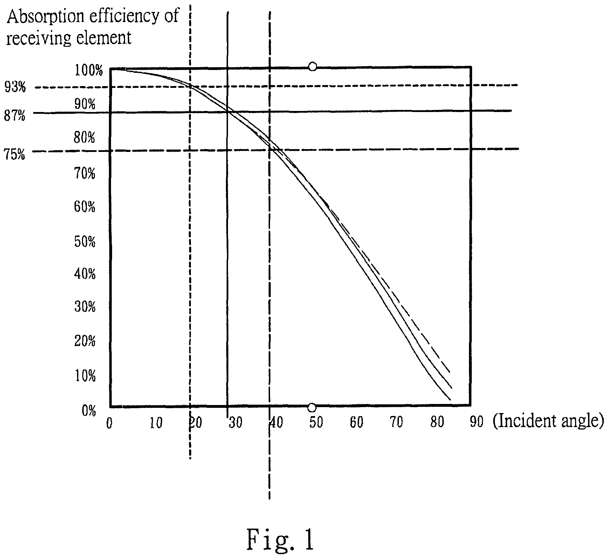

Thirdly, referring to Fig. 1, light incident angles and responses of a receiving element (or a chip) are illustrated. The chip has efficiency response of 100% when the angle of the light beam incident to the chip is zero degree (or defined as a perpendicular incidence), and the chip has efficiency response less than 87% when the angle of the light beam incident to the chip is greater than thirty degrees. In another word, the efficiency loss of the chip can be reduced (or the absorption efficiency and the photoelectric conversion efficiency of the chip can be increased) when the angle of the light beam incident to the chip is possibly kept less than thirty degrees.

Fourthly, in view of reducing the efficiency loss of the chip, the assembled structure and the related configurations and designs of the conventional primary and secondary optical elements shall be rearranged and considered. It shall be known how to arrange and design to reduce the loss of the incident light (or the sunlight incident to the chip) when the angle of the light beam incident to the chip is kept less than thirty degrees.

However, the above-described topics do not physically taught or implied in the cited reference data.

### BRIEF SUMMARY OF THE INVENTION

In view of this, the purpose of the present invent is to provide a light-collecting device and a light-collecting method thereof, capable of providing a simple combination structure, guiding light beams to be almost perpendicularly entered into a receiving element, and increasing the absorption efficiency of a light-receiving element. The light-collecting device includes a light concentrator provided with a focusing (point) region and a light collector provided with total internal reflection and assembled with a light-receiving element. The light collector is defined with a light-entering aperture which is disposed near or located at the focusing region of the light concentrator and a light-radiating aperture. At least part of light beam received by the light concentrator travels through the focusing (point) region of the light concentrator and forwardly radiates to a light collector, and the light beam travelling form the light collector is incident to the receiving element when the light beam is optically functioned by the total internal reflection of the light collector, thereby improving the photoelectric conversion efficiency caused by large or imperfect light incident angles and non-uniform optical illumination in the conventional structures.

According to the light-collecting device of the present invention, the light collector is formed by type of (circular) conical geometry profile (section) with respect to a reference axis served as a datum. The light-entering aperture of the light collector is disposed near or located at the focusing region of the light concentrator or the range connected therewith, and the receiving element is disposed at the light-radiating aperture of the light collector. Therefore, when at least part of light beam from the light source is received by the light concentrator and travels through the focusing (point) region of the light concentrator to forwardly radiate to the light collector and to be optically functioned or processed by the light collector with total internal reflection, the light beam incident to the light collector can be possibly kept within an angular range which is almost perpendicular to the light-receiving element (or less than thirty degrees).

According to the light-collecting device of the present invention, the light collector is disposed on a base portion, and the base portion comprises an opening which is utilized to receive the light collector, disposed near or located at the focusing region of the light concentrator and defined by profiled (section) type with a wide top zone and a narrow bottom zone by taking the reference axis as a reference direction. Therefore, the focusing region of the light concentrator is located near or at the top zone of the opening of the base portion, and the (light-entering) aperture of the light collector is located at the top zone of the opening of the base portion.

Practicably, by taking the reference axis as a reference direction, the base portion is formed on the bottom of the light concentrator, and the opening of the base portion (or the bottom portion) is defined by type of conical profile (or trapezoid section) with a wide top zone and a narrow bottom zone, wherein the inner diameter of the top zone is greater than that of the bottom zone of the opening, and the inner diameter of the bottom zone of the opening of the bottom portion of the light concentrator is approximately equal to the outer diameter of the light-radiating aperture of the light collector. Therefore, with the conical-type light collector capable of providing both vertical alignment and horizontal (right and left (or central)) alignment, it is particularly suitable for an operator to conveniently align the light collector with the bottom zone of the opening of the bottom portion, thus to assemble the light collector on the bottom portion (or the base portion).

Preferably, the opening of the base portion or the bottom portion comprises a surface or an inner surface coated with a layer of reflective film to form a reflective surface.

According to the light-collecting device of the present invention, the inner diameter of the bottom zone of the opening of the light concentrator or the inner diameter of the bottom zone of the opening of the base portion is approximately equal to the outer diameter or the length of the diagonal line of the (light-)receiving element.

According to a light-collecting method of the present invention, the optical design of inputting the light beam comprises the steps of: (a) providing the focusing (point) region of the light concentrator to receive at least part of light beam from a light source, and forwardly radiating the light beam traveled through the focusing region of the light concentrator to the light collector to form a first stage output light; and (b) optically functioning the first stage output light reached the light collector by total internal reflection of the light collector to radiate a second stage output light and the second stage output light reached a light-radiating aperture of the light collector entering into the (light-)receiving element.

According to another light-collecting method of the present invention, the optical design of inputting the light beam comprises the steps of: (a) providing a light concentrator comprising a focusing (point) region to receive at least part of light beam from a light source, and forwardly radiating the light beam travelling from the light concentrator onto the surface of an opening which is formed on a base portion (or a bottom portion) and provided with a surface after the light beam is deflected from the focusing region of the light concentrator; (b) radiating the light beam reflected from the surface of the opening of the base portion (or the bottom portion) to form a first stage output light; and (c) optically functioning the first stage output light reached a light collector by refraction and/or total internal reflection of the light collector to radiate a second stage output light and the second stage output light reached a light-radiating aperture of the light collector entering into the (light-)receiving element.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:

Fig. 1 is a schematic view showing light incident angles and responses of a receiving element;

Fig. 2 is a schematic view showing a structure of a light concentrator and a light collector of the present invention;

Fig. 3 is a schematic view showing an assembled structure of a light concentrator, a light collector and a base portion of the present invention;

Fig. 4 is a schematic view showing an assembled structure of a light concentrator of the present invention, wherein the light concentrator adopts a total internal reflection focal optical element;

Fig. 5 is a schematic view showing the illumination distribution of a light beam which travelling through a light concentrator in a primary optical process and a light collector in a secondary optical process;

Fig. 6 is a schematic view showing the light intensity distribution of a light beam travelling through a light concentrator in a primary optical process and a light collector in a secondary optical process;

Fig. 7 is a schematic view showing an exploded structure of a light concentrator and a light collector of the present invention;

Fig. 8 is a schematic perspective view showing an assembled structure of a light concentrator and a light collector of the present invention;

Fig. 9 is a cross-sectional view of the structure in Fig. 8, wherein an imaginary line illustrates a top portion of a light collector which is formed by type of curved surface;

Fig. 10 is a partially enlarged schematic view of the structure in Fig. 9;

Fig. 11 is a schematic view of a light-collecting device of the present invention, illustrating the paths of guided light beams travelling through a light concentrator in a primary optical process and a light collector in a secondary optical process;

Fig. 12 is a partially enlarged schematic view of the structure in Fig. 11;

Fig. 13 is a schematic block diagram of a light-collecting method for a light-collecting device of the present invention;

Fig. 14 is a schematic view of a light-collecting device of the present invention, illustrating the travelling paths of the deflected light beams incident to the light-collecting device;

Fig. 15 is a partially enlarged schematic view of the structure in Fig. 14;

Fig. 16 is a schematic block diagram of another light-collecting method for a light-collecting device of the present invention; and

Fig. 17 is a schematic block diagram of still another light-collecting method for a light-collecting device of the present invention.

### DETAILED DESCRIPTION OF THE INVENTION

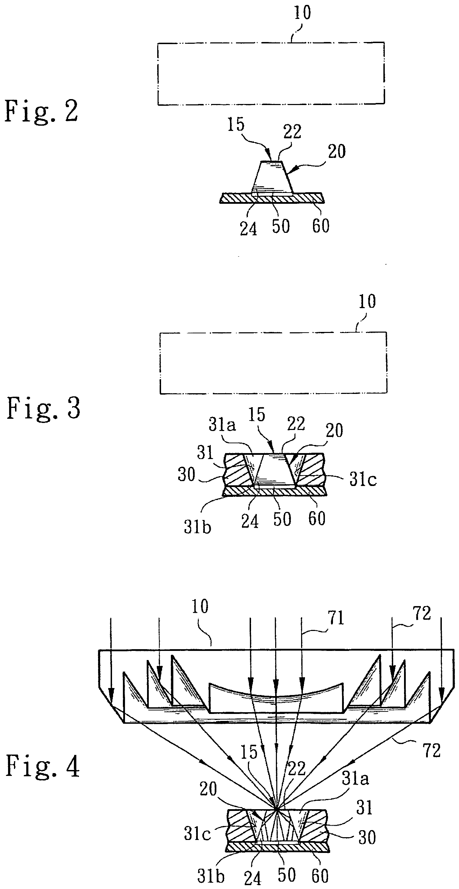

Referring to Fig. 2, a light-collecting device of the present invention comprises an assembly of a light concentrator and a light collector, which are represented by number references 10 and 20, respectively. The light concentrator 10 defined as a primary optical element comprises a focusing region 15. At least part of light beam received by the light concentrator 10 travels through the focusing region 15 of the light concentrator 10 and forwardly radiates to a light collector 20, and the light beam travelling form the light collector 20 is incident to a (light-)receiving element 50 when the light beam is optically functioned or processed by the light collector 20 with total internal reflection.

Referring to Fig. 2, the light collector 20 is optically designed of total internal reflection and defined as a secondary optical element. In the adopted embodiment, the light collector 20 is a light-transmissive and solid element formed by type of conical geometry profile shown by the section in Fig. 2 with respect to a reference axis 'x' served as a datum, and it is understood that the structural section formed by type of conical profile has a curve with a curvature of zero, i.e., a slanted line. The light collector 20 comprises a light-entering aperture 22 and a light-radiating aperture 24, wherein the light-entering aperture 22 is disposed near or at the focusing region 15 or the range connected therewith, and the receiving element 50 is disposed at the light-radiating aperture 24. Specifically speaking, the receiving element 50 is arranged on a base plate 60 which is made of ceramic, copper or other similar materials, as described in Fig. 2. In practice, the receiving element 50 and the base plate 60 are bonded to each other by a solder or tin paste therebetween, and the light collector 20 can be directly enclosed or packaged on the receiving element 50.

According to the sectional view of the light collector 20 in Fig. 2, it can be seen that the width or diameter of the light-entering aperture 22 is less than that of the light-radiating aperture 24. In brief, the light collector 20 is formed by a structure type with a narrow top portion and a wide bottom portion so that the light beam incident to the light collector 20 can be possibly kept within an angular range which is almost perpendicular to the light-receiving element 50 or less than thirty degrees, thereby increasing the absorption efficiency and the illumination uniformity of the light-receiving element 50, and the related contents will be described in detail hereinafter.

Referring to an executable embodiment in Fig. 3, the light collector 20 is disposed on a base portion 30 which can be integrally formed with the base plate 60 or can be fixedly bonded to the base plate 60 via an adhesive therebetween. The base portion 30 comprises or is defined with an opening 31 utilized to receive the light collector 20 therein, wherein the opening 31 is located near the focusing region 15 of the light concentrator 10 or the range connected therewith. By taking the reference axis 'x' as a reference direction, the opening 31 of the base portion 30 is defined by type of structural profile or section with a wide top zone 31a and a narrow bottom zone 31b. That is, from the section of the base portion 30 in Fig. 3, it can be seen that the width or diameter of the top zone 31a is greater than that of the bottom zone 31b. The focusing region 15 of the light concentrator 10 is located near or at the top zone 31a of the opening 31 of the base portion 30, and the light-entering aperture 22 of the light collector 20 is located at the top zone 31a of the opening 31 of the base portion 30.

Preferably, the opening 31 of the base portion 30 comprises a surface or an inner surface 31c coated with a layer of reflective film to form a reflective surface. It is needed to explain that, with the opening 31 of the base portion 30 defined with the wide top zone 31a and the narrow bottom zone 31b, an acceptance angle of the optical system can be increased. Thus, with the assembled structure of the light concentrator 10 and the light collector 20, the light beam incident to the light collector 20 can be incident to the light-receiving element 50 at a small angle (e.g., within thirty degrees as mentioned above); moreover, incorporated the top zone 31a, the bottom zone 31b and the surface 31c of the opening 31 of the base portion 30, the acceptance angle of the optical system can also be increased.

In a specific embodiment in Fig. 4, the light concentrator 10 adopts a total internal reflection (TIR) focal optical element having the focusing region 15, providing a structural type capable of matching the light collector 20, the base portion 30, and the opening 31 of the base portion 30, i.e., the light-entering aperture 22 of the light collector 20 is located at the focusing region 15 of the light concentrator 10. The focal optical element can be selected from Fresnel lens, TIR refractive lens or other similar optical systems.

Fig. 4 shows the condition that the incident light beam or sunlight being type of perpendicular incidence travels through the light concentrator 10 in a primary optical process and the light collector 20 in a secondary optical process. In the adopted embodiment, the incident light beam travelling through a middle part of the light concentrator 10 is denoted by a reference numeral '71', and the incident light beam travelling through a peripheral part of the light concentrator 10 is denoted by a reference numeral '72'.

In Fig. 4, the light beam 71 travelling through the light concentrator 10 is directly guided to the focusing region 15 of the light concentrator 10 to enter into the light collector 20 via the light-entering aperture 22 thereof, and then the light beam is uniformly and collectively incident to the light-receiving element 50, i.e., the refracted light beam 71 from the light concentrator 10 directly enters into the light-receiving element 50 without being functioned by the total internal reflection of the light collector 20. The light beam 72 entering the light concentrator 10 is guided by a serrated structure of the light concentrator 10 to the focusing region 15 of the light concentrator 10, the guided light beam 72 is radiated from the light-entering aperture 22 of the light collector 20 to form a first stage output light, and then the first stage output light is optically functioned by the total internal reflection of the light collector 20 to be uniformly incident to the light-receiving element 50.

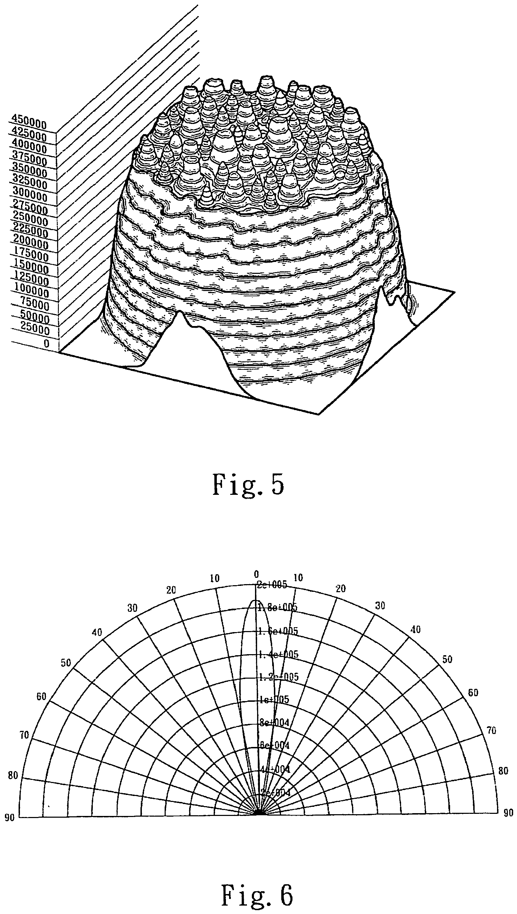

It is needed to explain that, after being optically functioned by the reflection of the light concentrator 10 and the total internal reflection of the light collector 20, the angular range of the light beams 71 and 72 incident to the light-receiving element 50 is kept within from zero to thirty degrees (or approximately from zero to forty degrees). In brief, the light beams 71 and 72 are incident to the light-receiving element 50 in an almost perpendicular way or within the angular range less than thirty degrees. According to the experimental simulations in Figs. 5 and 6, it is proved that this embodiment can provide perfect features of a small light incident angle to the light-receiving element 50, illumination uniformity and light intensity distribution, compared to the conventional skills.

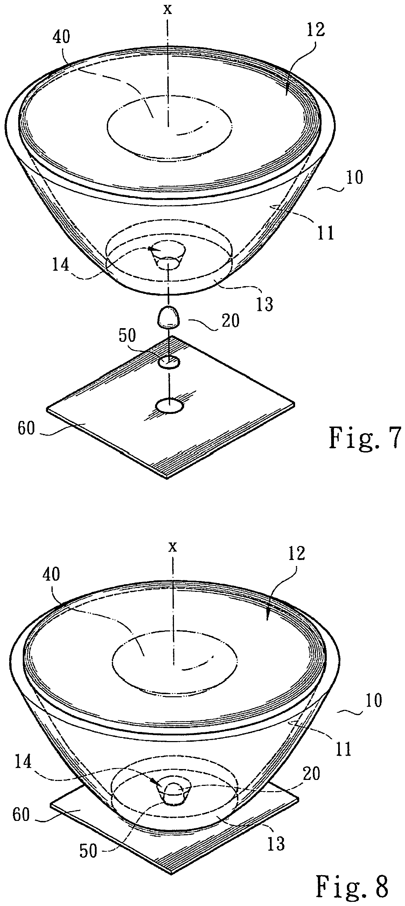

Referring to Figs. 7 and 8, Fig. 7 shows an exploded structure of a light concentrator 10 and a light collector 20 of another specific embodiment of the present invention, and Fig. 8 shows an assembled structure of the light concentrator 10 and the light collector 20. In another specific embodiment in Figs. 7 and 8, the light concentrator 10 having a reflective surface or curved surface 11 is a reflective optical design or an optical reflective mapping element. The reflective surface 11 of the light concentrator 10 is provided with a reflective layer made of reflective material. For example, the reflective surface 11 of the light concentrator 10 can be selected from a metallic surface reflective layer or a structure made of other materials capable of providing reflective effects.

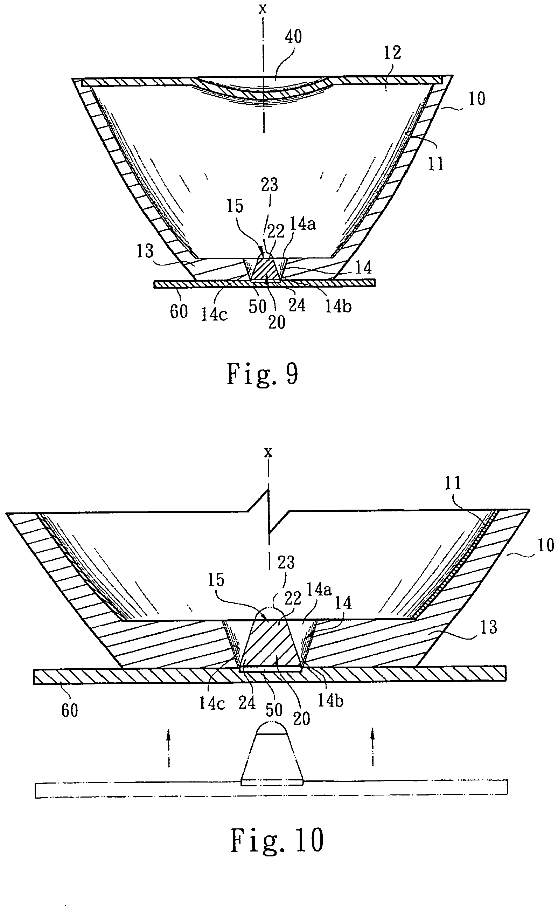

In Fig. 9, it particularly discloses that the volume of the light concentrator 10 is obviously greater than that of the light collector 20. In the adopted embodiment, the light collector 20 is arranged at a bottom portion 13 of the light concentrator 10, and the light collector 20 and the light concentrator 10 are assembled to each other via a bonding structure or integrally formed. Specifically speaking, the light concentrator 10 comprises a light-entering aperture 12 and an opening 14 (referred to 'light-radiating aperture') which is formed on the bottom portion 13 and located at the other end or an opposite side of the light-entering aperture 12, allowing to output the light beam via the opening 14. The light collector 20 is substantially received in or disposed at the opening 14 of the light concentrator 10 or inside a region where the opening 14 of the light concentrator 10 is located. Therefore, it is preferably considered that the height of the light collector 20 is approximately equal to the thickness of the bottom portion 13, as shown in Fig. 9.

In Fig. 9, a reference axis 'x' is served as a datum for the light concentrator 10 or for the reflective surface 11 of the light concentrator 10, and the light concentrator 10 is formed by type of dome profile, parabolic profile or other profiles. In the adopted embodiment, the light concentrator 10 adopts type of parabolic profile or section, so that the reflective surface 11 of the light concentrator 10 is formed by type of curved surface defining the focusing region 15, and the opening 14 is located near or at the focusing region 15. Therefore, the light-entering aperture 22 of the light collector 20 is located near or at the focusing region 15.

In an executable embodiment, the light-entering aperture 12 of the light concentrator 10 is disposed with a secondary light-concentrating element 40 which is selected from Fresnel lens, TIR refractive lens or other similar optical systems, allowing to output the light beam via the focusing region 15 of the light concentrator 10.

In comparison with the embodiment in Fig. 4, the embodiment in Fig. 9 utilizes the bottom portion 13 to serve as or replace the base portion 30 of the embodiment in Fig. 4. More specifically, by taking the reference axis 'x' as a reference direction, the opening 14 of the bottom portion 13 of the light concentrator 10 is formed by type of conical profile or trapezoid section. The opening 14 of the bottom portion 13 is defined by type of structural profile or section with a wide top zone 14a and a narrow bottom zone 14b, which is similar to the structure of the opening 31 of the base portion 30. That is, from the section in Fig. 9 or Fig. 10, it can be seen that, the width or inner diameter of the top zone 14a is greater than that of the bottom zone 14b of the opening 14 of the bottom portion 13 of the light concentrator 10, and the width or inner diameter of the bottom zone 14b of the opening 14 of the bottom portion 13 of the light concentrator 10 (or the bottom zone 31b of the opening 31 of the base portion 30 in Fig. 4) is approximately equal to or slightly greater than the width or outer diameter of the light-radiating aperture 24 of the light collector 20. With the conical-type light collector 20 formed with the narrow top portion and the wide bottom portion and similarly functioned as a guiding post capable of providing both vertical alignment and horizontal (or right and left (or central)) alignment, it is particularly suitable for an operator to conveniently align the light collector 20 with the bottom zone 14b of the opening 14 of the bottom portion 13 for insertion, thus to assemble the light collector 20 and the light concentrator 10 as shown in Fig. 10.

The opening 14 of the light concentrator 10 comprises a surface or an inner surface 14c coated with a layer of reflective film to form a reflective surface capable of increasing the acceptance angle of the optical system, and the related contents will be described in detail hereinafter.

In a preferred consideration, the inner diameter of the bottom zone 14b of the opening 14 of the light concentrator 10 or the inner diameter of the bottom zone 31b of the opening 31 of the base portion 30 is approximately equal to the outer diameter or the length of the diagonal line of the receiving element 50.

In practice, the receiving element 50 and the base plate 60 are bonded to each other by a solder or tin paste therebetween, and an adhesive is applied between the bottom portion 13 of the light concentrator 10 and the base plate 60 to bond the light concentrator 10 and the base plate 60. Further, the area or volume of the base plate 60 can be altered according to the actual requirements or the conditions on the job sites.

In a modified embodiment in Figs. 9 and 10, a top portion surface (or a boundary surface) or the light-entering aperture 22 of the light collector 20 is formed by type of curved surface 23 shown by an imaginary line. With the design of the curved surface 23 of the light collector 20, the reflection loss of the large-angled incident light beam can be possibly reduced when reaching the light collector 20, compared to a light collector with a plane surface. In an executable consideration, as shown in Fig. 3 or 9, the height (or position) of the light collector 20 can be slightly lower or higher than the height (or position) of the opening 14 of the light concentrator 10 and the opening 31 of the base portion 30.

Besides, the following conditions and considerations may be further provided.

The width (or the inner diameter) of the bottom zone 14b of the opening 14 of the light concentrator 10 is approximately equal to or slightly greater than the width (or the outer diameter) of the receiving element 50; the width (or the inner diameter) of the bottom zone 14b of the opening 14 of the light concentrator 10 (or the bottom zone 31b of the opening 31 of the base portion 30) is approximately equal to or slightly greater than the length of the diagonal line of the receiving element 50; the width (or the inner diameter) of the (light-radiating) aperture 24 of the light collector 20 is approximately equal to the width (or the outer diameter) of the receiving element 50; and the width (or the inner diameter) of the (light-radiating) aperture 24 of the light collector 20 is approximately equal to the length of the diagonal line of the receiving element 50.

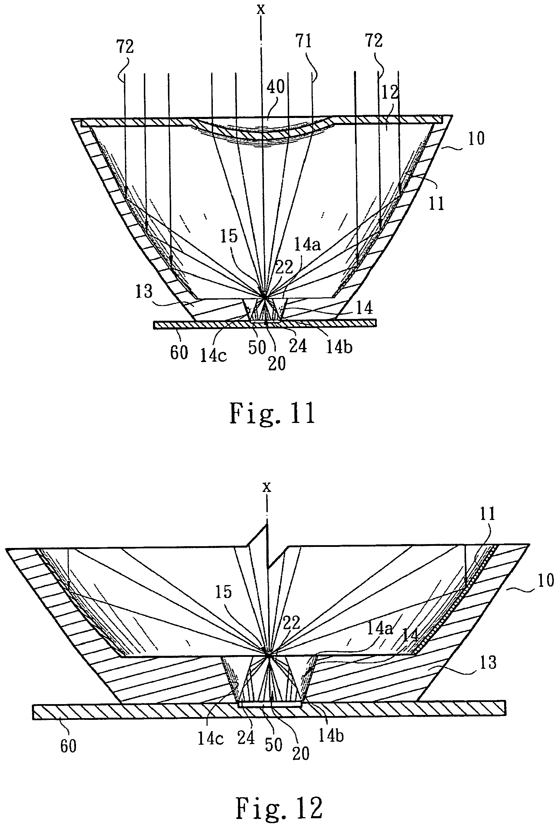

Figs. 11 and 12 show the condition that the incident light beam or sunlight being type of perpendicular incidence travels through the light concentrator 10 in a primary optical process and the light collector 20 in a secondary optical process. In the adopted embodiment, the incident light beam travelling through a secondary light-concentrating element 40 is denoted by a reference numeral `71', and the incident light beam not travelling through the secondary light-concentrating element 40 is denoted by a reference numeral `72'.

In Figs. 11 and 12, the light beam 71 travelling through the secondary light-concentrating element 40 is directly guided to the focusing region 15 of the light concentrator 10 to enter into the light collector 20 via the opening 14 of the light concentrator 10 (or the light-entering aperture 22 of the light collector 20), and then the light beam entered into the light collector 20 is uniformly incident to the light-receiving element 50 at an angle almost perpendicular to the light-receiving element 50. The light beam 72 entering the light concentrator 10 is reflected by the reflective surface 11 of the light concentrator 10 and travelled through the focusing region 15 of the light concentrator 10, and then the light beam 72 travelling from the focusing region 15 of the light concentrator 10 is radiated from the opening 14 of the light concentrator 10 (or the light-entering aperture 22 of the light collector 20) to form a first stage output light, and then the first stage output light is optically functioned by the total internal reflection of the light collector 20 to be uniformly incident to the light-receiving element 50.

It is needed to explain that, after being optically functioned by the refraction/reflection of the light concentrator 10 and the total internal reflection of the light collector 20 illustrated in Figs. 11 and 12, the angular range of the incident light beam to the light-receiving element 50 is kept within from zero to thirty degrees or approximately from zero to forty degrees. As the experimental simulations shown in Figs. 5 and 6, it is proved that this embodiment can provide perfect illumination uniformity and light intensity distribution, compared to the conventional skills.

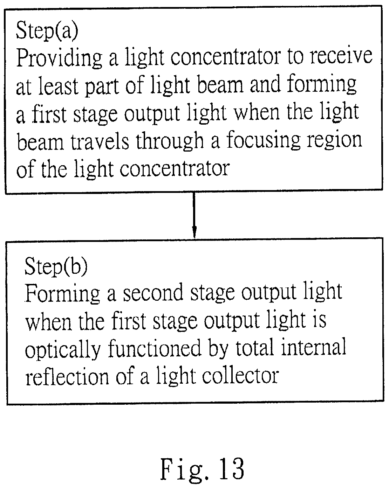

Referring to Fig. 13 and according to the above-described embodiments, a light-collecting method for the light-collecting device of the present invention is provided. In the light-collecting method of the present invention, the optical design of inputting the light beam comprises the steps of:

(a) providing the focusing region 15 of the light concentrator 10 to receive at least part of light beam from a light source, and forwardly radiating the light beam traveled through the focusing region of the light concentrator 10 to the light collector 20 to form a first stage output light and (b) optically functioning the first stage output light reached the light collector by total internal reflection of the light collector to radiate a second stage output light and the second stage output light reached a light-radiating aperture of the light collector entering into the (light-)receiving element.

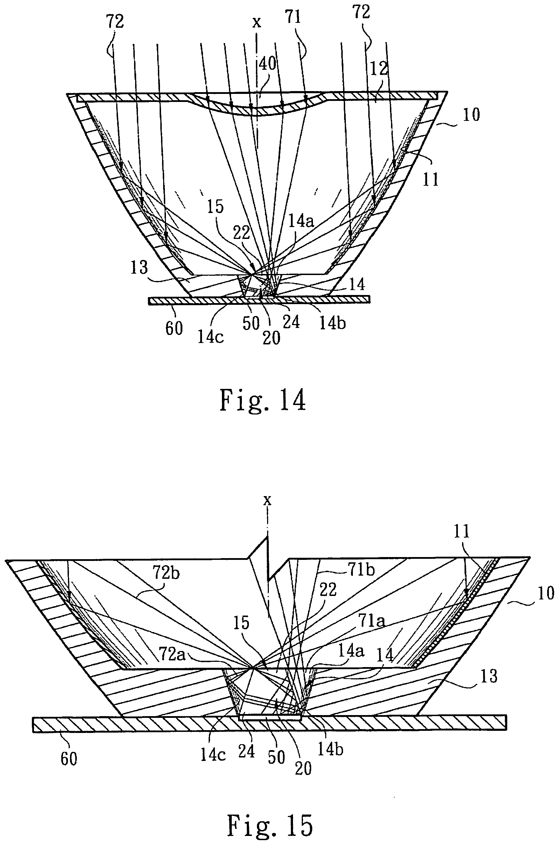

As mentioned above, the opening 14 of the light concentrator 10 comprises the surface or inner surface 14c coated with the reflective film to form the reflective surface. Referring also to Figs. 14 and 15, it is particularly illustrated that a deviation (or deflection angle) phenomenon is occurred when the angle of the light beam or sunlight incident to the light-collecting device belongs to a type of non-straight direction. In comparison with the embodiment in Figs. 11 and 12, it can be seen that in Figs. 14 and 15, when the light beam 71 travelling through the secondary light-concentrating element 40, a partial light beam 71a refracted from the secondary light-concentrating element 40 travels through the opening 14 of the light concentrator 10 and crosses the light collector 20 (or the focusing region 15 of the light concentrator 10) to radiate to and reflect from the surface 14c (or the reflective surface) of the opening 14, thus to form a first stage output light. The first stage output light reaching the light collector 20 is optically functioned by total internal reflection of the light collector 20 to radiate a second stage output light, and the second stage output light reaching the light-radiating aperture 24 of the light collector 20 is incident to the (light-)receiving element 50.

Further, in Figs. 14 and 15, a partial light beam 71b refracted from the secondary light-concentrating element 40 is deflected from the focusing region 15 of the light concentrator 10 to directly radiate to the light collector 20 and then to enter into the (light-)receiving element 50.

In Figs. 14 and 15, when the light beam 72 reflected from the reflective surface 11 of the light concentrator 10, a partial light beam 72a formed therefrom travels through the opening 14 of the light concentrator 10 and crosses the light collector 20 (or the focusing region 15 of the light concentrator 10) to radiate to and reflect from the surface 14c (or the reflective surface) of the opening 14, thus to form a first stage output light. The first stage output light reaching the light collector 20 is optically functioned by refraction and/or total internal reflection of the light collector 20 to radiate a second stage output light, and the second stage output light reaching the light-radiating aperture 24 of the light collector 20 is incident to the (light-)receiving element 50.

Further, in Figs. 14 and 15, a partial light beam 72b reflected from the reflective surface 11 of the light concentrator 10 is deflected from the focusing region 15 of the light concentrator 10 to directly radiate to and to be optically functioned by refraction and/or total internal reflection of the light collector 20, and then to enter into the (light-)receiving element 50.

In practice, it can be understood that the partial light beams 71a, 71b, 72a and light beam 72b crossing the light collector 20 makes a very small impact on the total light-collecting efficiency or light-collecting proportion, but the light-collecting device of the above-described embodiment provided with a large acceptance angle of the optical system still can allow the processed light beams, which are formed after the partial light beams 71a, 71b, 72a and 72b is optically functioned via the reflective surface 11 or the surface or inner surface 14c of the opening 14 of the light concentrator 10 and then optically functioned by the refraction/reflection of the light collector 20, to enter into the (light-)receiving element 50. That is, the light-collecting device of the above-described embodiment is not only provided with perfect features of the small light incident angle to the light-receiving element 50, illumination uniformity and light intensity distribution, but also is featured with an optical function of larger acceptance angle of the optical system.

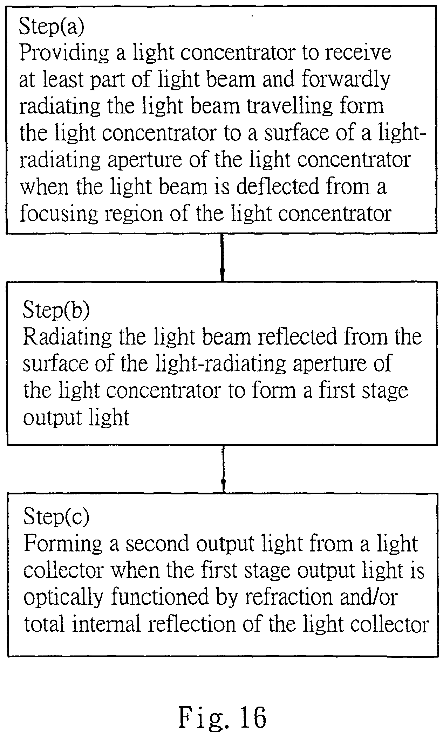

Referring to Fig. 16 and according to the description above, the light-collecting device of the present invention further comprises another light-collecting method for the light-collecting device. In this method of the present invention, the optical design of inputting the light beam comprises the steps (a), (b) and (c) as follows.

(a) The focusing region 15 of the light concentrator 10 is provided to receive at least part of light beam from a light source, and the light beam travelling from the light concentrator 10 is forwardly radiated to the surface 14c of an opening 14 of the light concentrator 10 after the light beam is deflected from the focusing region 15 of the light concentrator 10.

As to the light concentrator 10 receiving at least part of the light beam, it means that the light beams, which include the light beam 71a travelling through the secondary light-concentrating element 40 and the light beam 72a reflected by the reflective surface 11 of the light concentrator 10, are formed by type of deflection angle to enter into the light concentrator 10, relative to the reference axis 'x' as a reference direction.

(b) The light beam reflected from the surface of the opening 14 of the light concentrator 10 is radiated to form a first stage output light.

(c) When the first stage output light reaching the light collector 20 is optically functioned by refraction and/or total internal reflection of the light collector 20, a second stage output light is radiated from the light collector 20 to enter into the (light-)receiving element 50 after the second stage output light reaches a light-radiating aperture of the light collector.

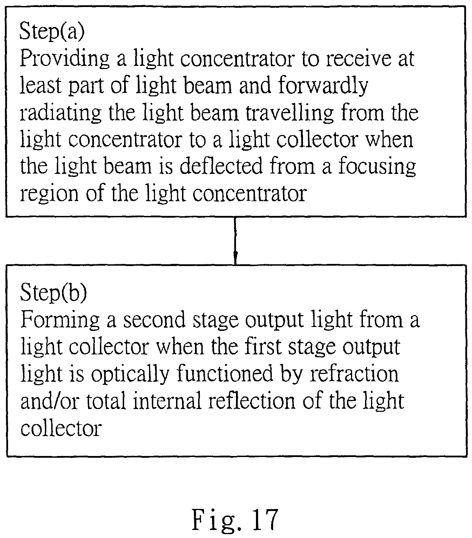

Referring to Fig. 17 and according to the description above, the light-collecting device of the present invention further comprises another light-collecting method for the light-collecting device. In this method of the present invention, the optical design of inputting the light beam comprises the steps (a) and (b) as follows.

(a) The light concentrator 10 is provided to receive at least part of light beam from a light source, and the light beam travelling from the light concentrator 10 is forwardly radiated to the light collector 20 to form a first stage output light after the light beam is deflected from the focusing region 15 of the light concentrator 10.

As to the light concentrator 10 receiving at least part of the light beam, it means that the light beams, which include the light beam 71b travelling through the secondary light-concentrating element 40 and the light beam 72b reflected by the reflective surface 11 of the light concentrator 10, are formed by type of deflection angle to enter into the light concentrator 10, relative to the reference axis 'x' as a reference direction.

(b) When the first stage output light is optically functioned by refraction and/or total internal reflection of the light collector 20, a second stage output light is radiated from the light collector 20 to enter into the (light-)receiving element 50.

In a derivative embodiment, the light collector 20 can be considerably formed by type of parabolic profile or section (not shown in Figs.) comprising a focusing (point) region and a light-entering aperture 22 formed at the focusing (point) region, wherein the focusing (point) region of the light collector 20 and the focusing region 15 of the light concentrator 10 are formed by a confocal (point) type or are approximately formed by a confocal type within a range, and the light-entering aperture 22 of the light collector 20 is approximately located at the top zone 14a of the opening 14 of the bottom portion 13 or the focusing region 15 of the light concentrator 10. In this embodiment, the light collector 20 is also defined with a light-radiating aperture 24 relative to the other side or the opposite side of the light-entering aperture 22. In practice, the receiving element 50 is disposed on the light-radiating aperture 24 of the light collector 20.

It is to be understood that, the traveling condition of the light beam of this derivative embodiment is similar to the paths of the light beams in Figs. 11, 12, 14 and 15. Further, in this embodiment, the focusing (point) region through which the light beam travels can be inclusively defined by a confocal (point) type or is approximately defined by a confocal type, wherein the focusing (point) region is referred to the confocal region or range of the focusing region 15 of the light concentrator 10 and the focusing region of the light collector.

Representatively speaking, the light-collecting device and the light-collecting method thereof in the present invention provide a simplified structure based on the design considerations as follows.

First, the assembled structure of the light-collecting device in the design and manufacturing processes is simplified, capable of reducing the manufacturing cost and increasing the accuracies of the light-concentrating element and the light receiving element, increasing the stabilities of the conversion performance and generator efficiency of the light-collecting device, and improving the illumination uniformity of conventional structures to increase the photoelectric conversion efficiency.

Accordingly, the light-collecting device of the present invention shall be provided with the structural features as follows.

Firstly, the light collector 20 shall have the profile or section formed by the structure type with the narrow top portion and the wide bottom portion so that the light beams incident to the light collector 20 can be possibly kept within an angular range which is almost perpendicular to (i.e., zero degree) the light-receiving element 50, thereby attaining uniform illumination distribution of the light-receiving element 50. Further, the diameter of the bottom zone 14b of the opening 14 of the bottom portion 13 of the light concentrator 10 (or the bottom zone 31b of the opening 31 of the base portion 30) is approximately equal to or slightly greater than the outer diameter of the light collector 20, or the diameter of the bottom zone 14b of the opening 14 of the bottom portion 13 of the light concentrator 10 (or the bottom zone 31b of the opening 31 of the base portion 30) is approximately equal to or slightly greater than the outer diameter (or the length of the diagonal line) of the receiving element 50. In addition, due to the light collector 20 similarly formed as the guiding post, the alignment and assembly processes of the light collector 20 and the light concentrator 10 in vertical and horizontal (or central) directions can be facilitated.

Secondly, unlike the structural type of the light collector 20, the light concentrator 10 and the base portion 30 particularly adopt the internal reflection optical elements which have the openings 14 and 31 respectively defined by structural type with the wide top zone and the narrow bottom zone, so that a large acceptance angle can be provided to guide the light beam into the light-receiving element 50 even though the deflected light beam is incident to the light-collecting device.

Thirdly, with the consideration of the opening 14 of the light concentrator 10 defined by the structural type with the wide top zone and the narrow bottom zone, it is advantageous that the reflective surface formed the surface or inner surface 14c of the opening 14 of the light concentrator 10 and the reflective layer coated on the reflective surface 11 of the light concentrator 10 can be completed in the same process, thereby increasing the efficiency of film-coating processes and obtaining ideal film thickness uniformity, compared to the individual or different processes in conventional skills.

Fourthly, in the light-collecting device of the present invention, it is particularly and considerably to incorporate the angle design of the light beam incident to the receiving element 50 (or a chip) into the configuration design of the primary optical process of the light concentrator 10 and the secondary optical process of the light collector 20, which is much different from the conventional design only focusing on uniformity of the light beam incident to the receiving element (i.e., uniform light effect) or increment of acceptance angle of the receiving element.

Fifthly, in Figs. 11 and 12 of the light-collecting device of the present invention, the angle of the light beam incident to the receiving element 50 (or a chip) is kept within an angular range less than thirty degrees, thereby reducing the efficiency loss of the receiving element 50 (or increasing the absorption efficiency and the photoelectric conversion effect of the chip).

Sixthly, as mentioned above, the light-collecting device of the present invention is capable of reducing the efficiency loss of the chip, and therefore the combination structure and related configuration design of the primary optical element (i.e., the light concentrator 10) and the secondary optical element (i.e., the light collector 20) shall be correspondingly rearranged and reconsidered.

In summary, the inventive light-collecting device and the light-collecting method thereof in the present invention effectively provide unique functionalities and spatial type and are different from that in the conventional skills.

While this invention has been described in connection with what is presently considered to be the most practical and preferred embodiment, it is to be understood that the invention is not limited to the disclosed embodiments, but, on the contrary, is intended to cover various modifications and equivalent arrangements included within the spirit and scope of the appended claims.

## Claims

1. A light-collecting device, comprising:
a light concentrator comprising a focusing region;
a light collector being type of light-transmissive and solid and formed by a structure type with a narrow top portion and a wide bottom portion to be arranged near the focusing region of the light concentrator, comprising a light-entering aperture and a light-radiating aperture; and
a light-receiving element disposed near the light-radiating aperture of the light collector, receiving at least part of light beam optically functioned by the light collector with at least one time total internal reflection.

2. The light-collecting device as claimed in claim 1, wherein the light-entering aperture of the light collector is disposed near the focusing region of the light concentrator.

3. The light-collecting device as claimed in claim 1, wherein the light collector is utilized to cover on the light-receiving element.

4. The light-collecting device as claimed in claim 1, wherein the light collector is disposed on a base portion, and the base portion substantially comprises an opening which is utilized to receive the light collector, disposed near the focusing region of the light concentrator and defined by structure type with a wide top zone and a narrow bottom zone.

5. The light-collecting device as claimed in claim 4, wherein the top zone of the opening of the base portion is located near the focusing region of the light concentrator, and the light-entering aperture of the light collector is located near the top zone of the opening of the base portion.

6. The light-collecting device as claimed in claim 4, wherein the opening of the base portion comprises a surface coated with a layer of reflective film to form a reflective surface.

7. The light-collecting device as claimed in claim 1, wherein the light concentrator is a reflective optical element formed by type of geometry profile and comprising a light-entering aperture, a reflective surface, a bottom portion, and an opening formed on the bottom portion and located at an opposite side of the light-entering aperture, the light collector is disposed in the opening of light concentrator, and the opening of light concentrator is located near the focusing region of the light concentrator and defined with structure type with a wide top zone and a narrow bottom zone.

8. The light-collecting device as claimed in claim 7, wherein the top zone of the opening of light concentrator is located near the focusing region of the light concentrator, and the light-entering aperture of the light collector is located near the top zone of the opening of light concentrator.

9. The light-collecting device as claimed in claim 7, wherein the opening of the light concentrator comprises a surface coated with a layer of reflective film to form a reflective surface.

10. The light-collecting device as claimed in claim 7, wherein the light collector has a height approximately equal to the thickness of bottom portion of the light concentrator.

11. The light-collecting device as claimed in claim 4 or 7, wherein an inner diameter of the bottom zone of the opening of the base portion and an inner diameter of the bottom zone of the opening of the light concentrator are slightly greater than an outer diameter of the light-receiving element.

12. The light-collecting device as claimed in claim 1, wherein the light-entering aperture of the light collector is formed by type of curved surface.

13. The light-collecting device as claimed in claim 7, wherein the light-entering aperture of the light concentrator is disposed with a secondary light-concentrating element.

14. The light-collecting device as claimed in claim 4, wherein the light-receiving element is disposed on a base plate which is formed by a combination type together with the base portion.

15. The light-collecting device as claimed in claim 7, wherein the light-receiving element is disposed on a base plate which is formed by a combination type together with the bottom portion of the light concentrator.

16. The light-collecting device as claimed in claim 1, wherein the light collector formed by type of parabolic profile comprises a focusing region which is formed by an approximate confocal type together with the focusing region of the light concentrator.

17. A method for collecting a light beam for a light-collecting device, comprising:
(a) providing a light concentrator comprising a focusing region to receive at least part of the light beam, and forwardly radiating the light beam travelling from the light concentrator to a light-transmissive and solid light collector to form a first stage output light when the light beam is traveled through the focusing region of the light concentrator; and
(b) radiating a second stage output light from the light collector when the first stage output light reaching the light collector is optically functioned by total internal reflection of the light collector and entering the second stage output light into a receiving element.

18. A method for collecting a light beam for a light-collecting device, comprising:
(a) providing a light concentrator comprising a focusing region to receive at least part of light beam from a light source and forwardly radiating the light beam deflected from the focusing region of the light concentrator to a light-transmissive and solid light collector to form a first stage output light; and
(b) optically functioning the first stage output light by refraction and/or total internal reflection of the light collector to form a second stage output light to enter into a light-receiving element.
